# EUROPEAN PATENT APPLICATION

(11) **EP 4 626 175 A1**
(43) Date of publication of application: **01.10.2025**
(21) Application number: 25154037.3
(22) Date of filing: 27.01.2025
(51) Int. Cl.: H10D 84/01, H10D 30/01, H10D 30/43, H10D 30/00, H10D 84/03, H10D 84/83

(54) **GATE-ALL-AROUND DEVICES WITH MODULATED NUMBER OF ACTIVE NANORIBBONS**

(30) Priority: 29.03.2024 US 202418621798
(71) Applicant: INTEL Corporation, Santa Clara, CA 95054 (US)
(72) Inventor: ZHANG, Kan, Hillsboro, 97123 (US); CHU, Tao, Portland, 97229 (US); XU, Guowei, Portland, 97229 (US); LIN, Chung-Hsun, Portland, 97229 (US); MURTHY, Anand, Portland, 97229 (US); ZHANG, Yang, Rio Rancho, 87124 (US); CHAO, Robin, Portland, 97209 (US); HUNG, Ting-Hsiang, Beaverton, 97007 (US); ZHANG, Feng, Portland, 97229 (US); LIN, Chia-Ching, Portland, 97229 (US); YEUNG, Chun Wing, Portland, 97229 (US)
(74) Representative: Goddar, Heinz J.

(57) **Abstract**

Techniques to form semiconductor devices having only a subset of their total number of nanoribbons (or other semiconductor bodies) participating in an active channel region. In an example, any number of semiconductor devices includes a set of nanoribbons extending in a first direction and a gate structure extending in a second direction over each of the nanoribbons. Source or drain regions are formed at the ends of only a subset of the total number of nanoribbons, such that at least one of the nanoribbons does not contact the source or drain regions. In this way, the effective size of the device may be modulated based on how many nanoribbons are active (e.g., coupled to the source or drain regions). Different numbers of nanoribbons may be active for different devices across the same substrate or die.

## Description

### BACKGROUND

As integrated circuits continue to scale downward in size, a number of challenges arise. For instance, reducing the size of memory and logic cells is becoming increasingly more difficult. Different transistor architectures that maximize available semiconductor surfaces to form active channels have been contemplated, including gate-all-around and forksheet architectures. However, such architectures come with drawbacks with regards to the lack of variability amongst the design of the devices. It can be challenging to adjust the performance between transistors on the same die. Accordingly, there remain a number of non-trivial challenges with respect to forming certain transistor structures.

### BRIEF DESCRIPTION OF THE DRAWINGS

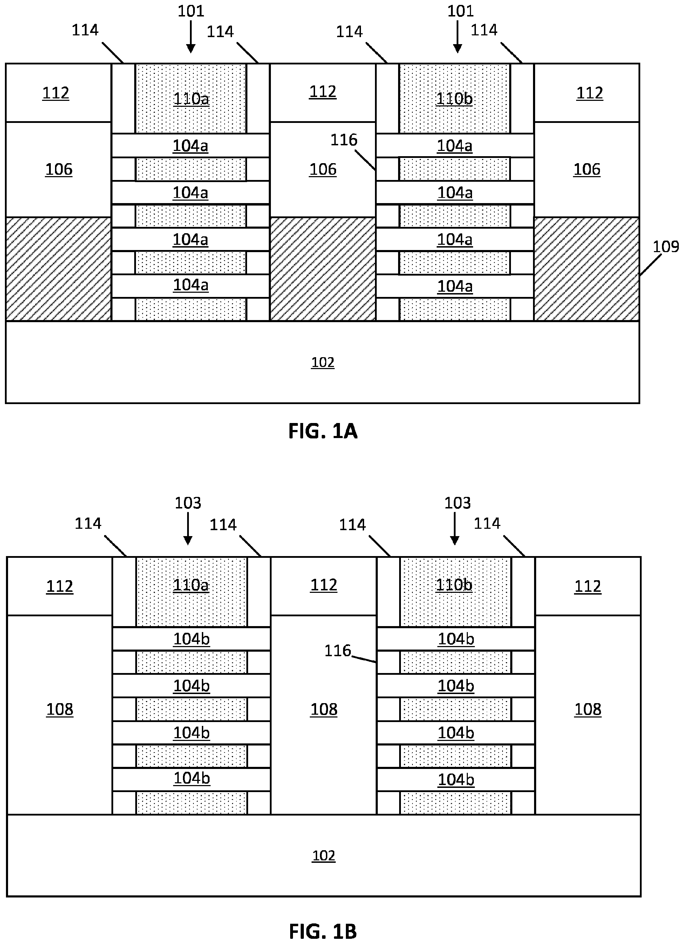

Figure 1A is a cross-sectional view of a pair of semiconductor devices with source or drain regions in contact with only a subset of the total number of nanoribbons, in accordance with an embodiment of the present disclosure.
Figure 1B is a cross-sectional view of another pair of semiconductor devices on the same die as the devices from Figure 1A, in accordance with an embodiment of the present disclosure.

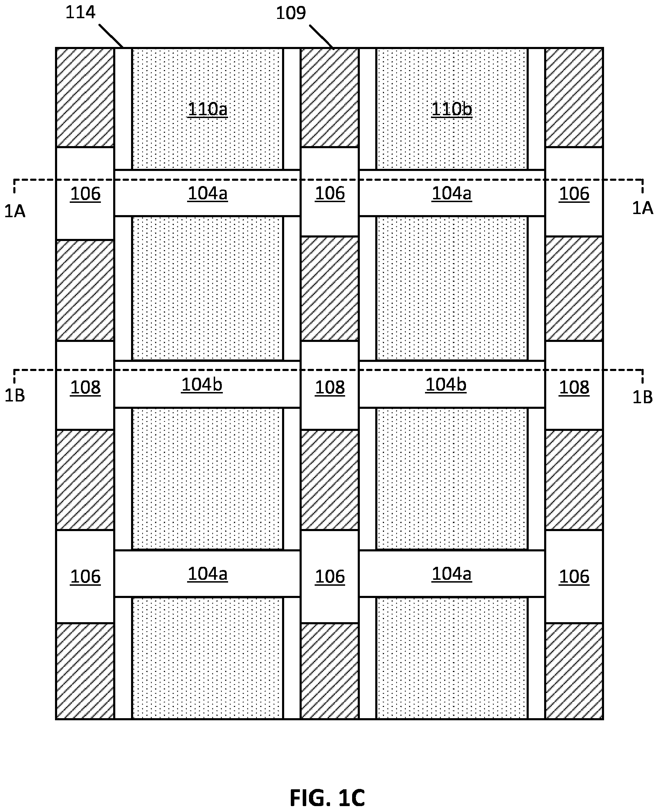

Figure 1C is a plan view of a portion of an integrated circuit that includes the pair of semiconductor devices from Figure 1A and the pair of semiconductor devices from Figure 1B.

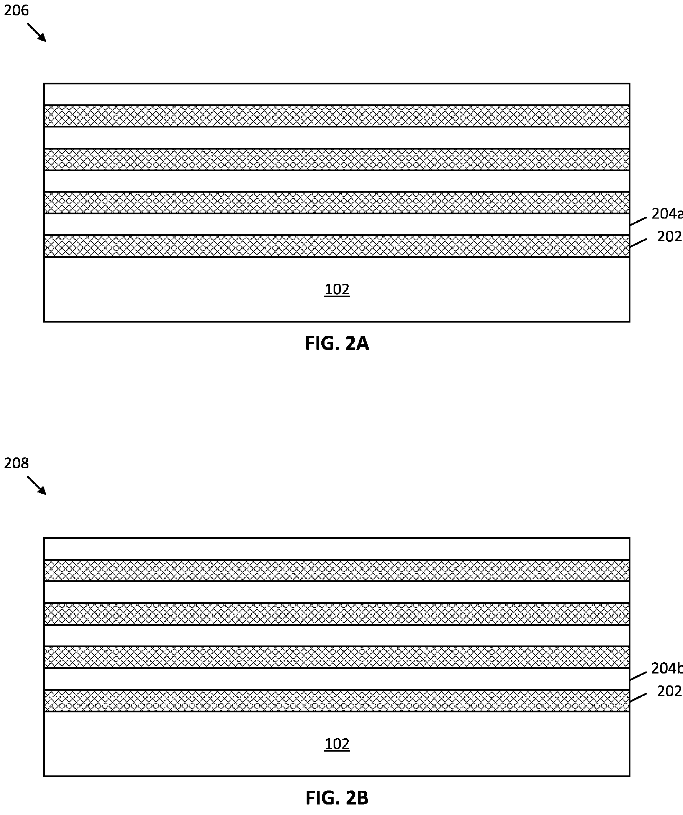

Figures 2A and 2B are cross-sectional views that illustrate one stage in an example process for forming an integrated circuit configured with one or more devices having source or drain regions in contact with only a subset of the total number of nanoribbons, in accordance with an embodiment of the present disclosure.

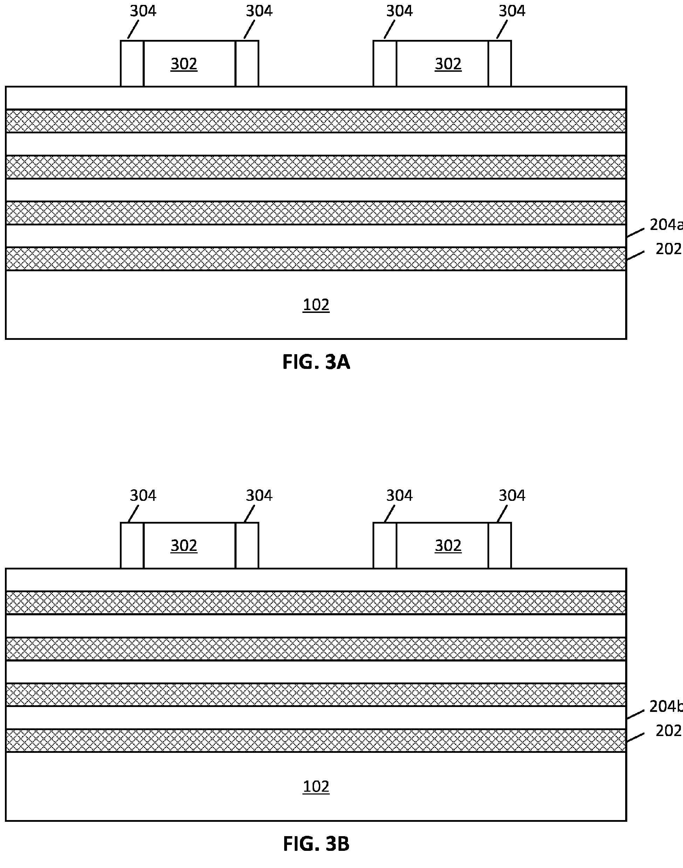

Figures 3A and 3B are cross-sectional views that illustrate another stage in the example process for forming an integrated circuit configured with one or more devices having source or drain regions in contact with only a subset of the total number of nanoribbons, in accordance with an embodiment of the present disclosure.

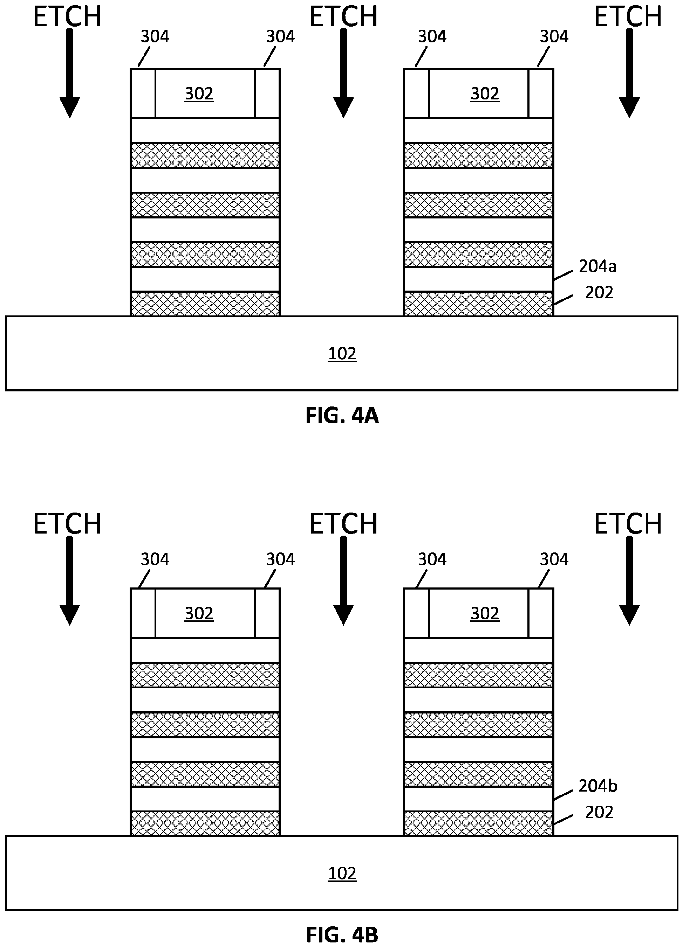

Figures 4A and 4B are cross-sectional views that illustrate another stage in the example process for forming an integrated circuit configured with one or more devices having source or drain regions in contact with only a subset of the total number of nanoribbons, in accordance with an embodiment of the present disclosure.

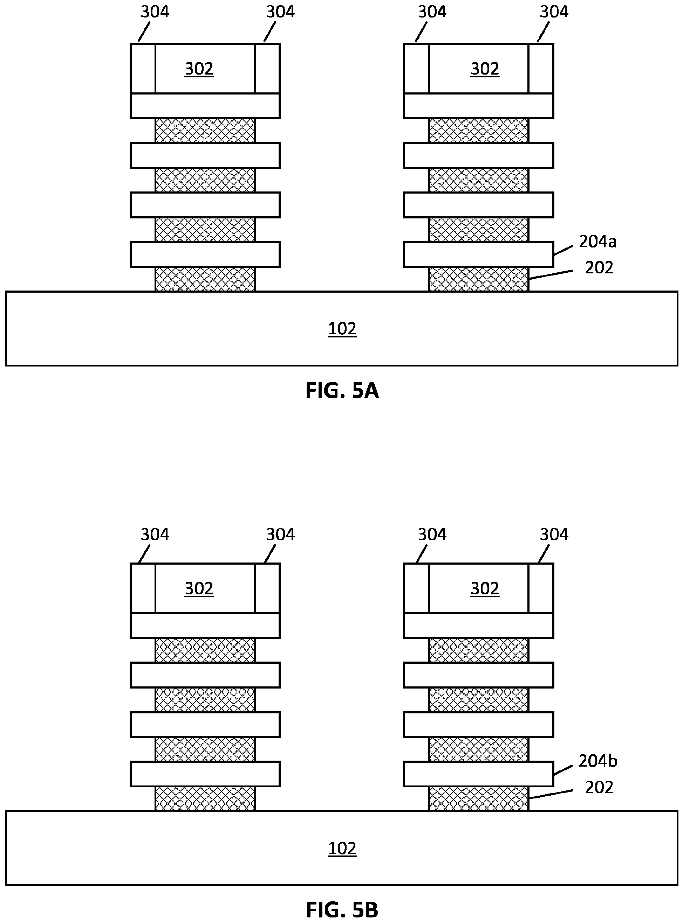

Figures 5A and 5B are cross-sectional views that illustrate another stage in the example process for forming an integrated circuit configured with one or more devices having source or drain regions in contact with only a subset of the total number of nanoribbons, in accordance with an embodiment of the present disclosure.

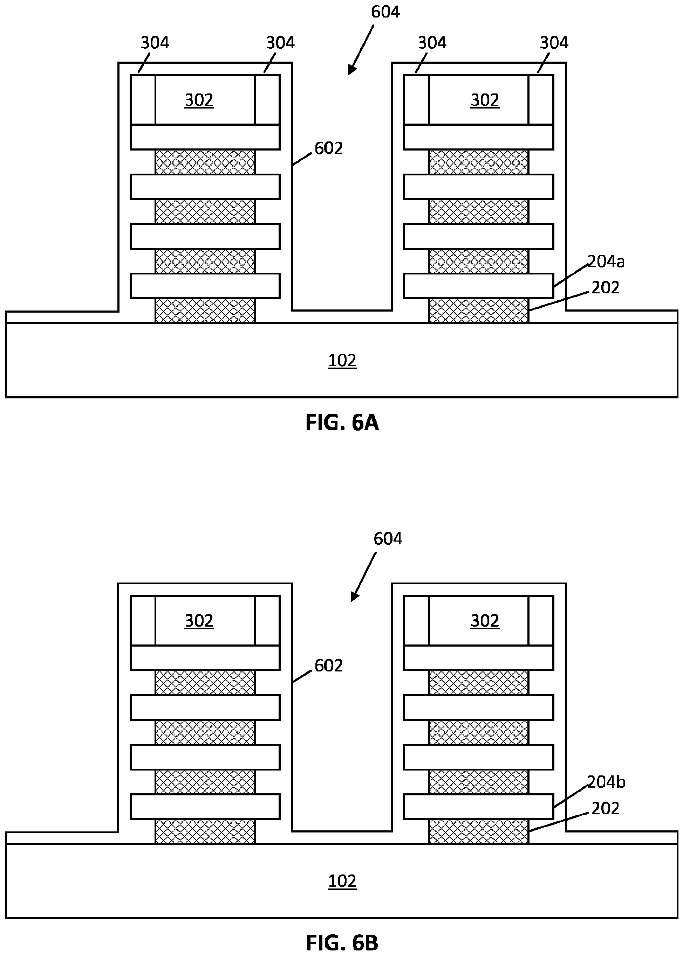

Figures 6A and 6B are cross-sectional views that illustrate another stage in the example process for forming an integrated circuit configured with one or more devices having source or drain regions in contact with only a subset of the total number of nanoribbons, in accordance with an embodiment of the present disclosure.

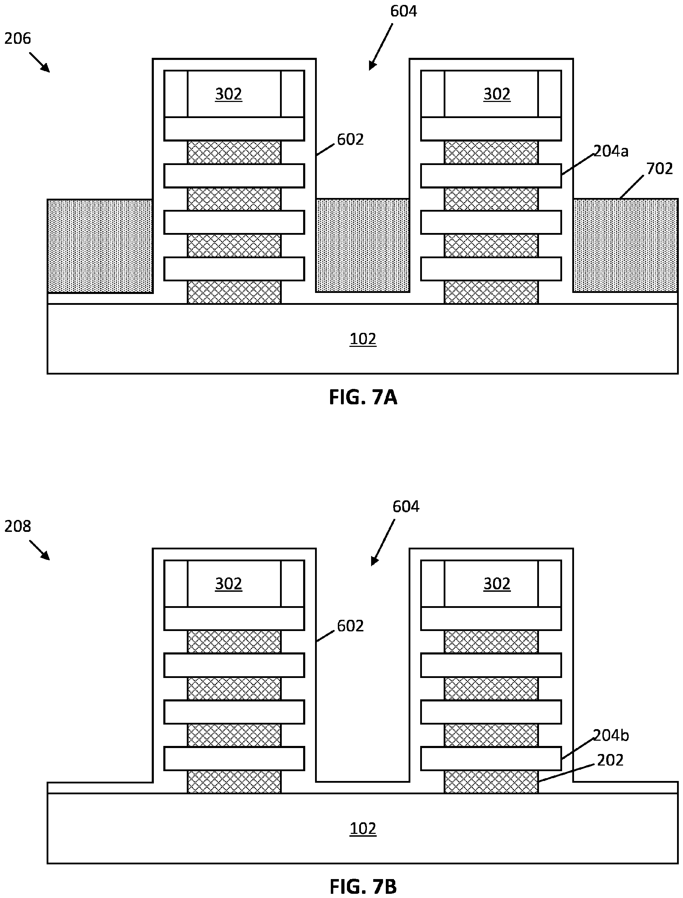

Figures 7A and 7B are cross-sectional views that illustrate another stage in the example process for forming an integrated circuit configured with one or more devices having source or drain regions in contact with only a subset of the total number of nanoribbons, in accordance with an embodiment of the present disclosure.

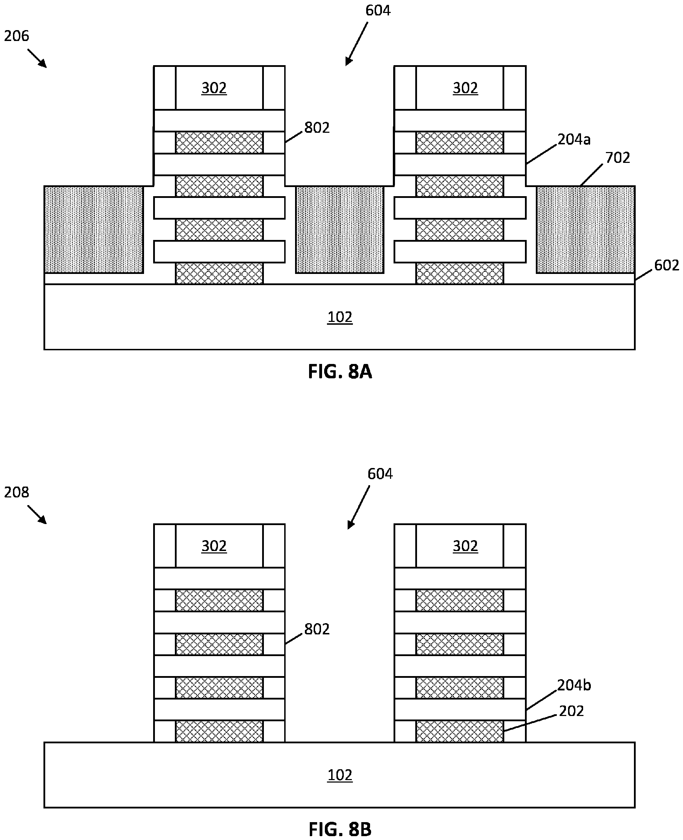

Figures 8A and 8B are cross-sectional views that illustrate another stage in the example process for forming an integrated circuit configured with one or more devices having source or drain regions in contact with only a subset of the total number of nanoribbons, in accordance with an embodiment of the present disclosure.

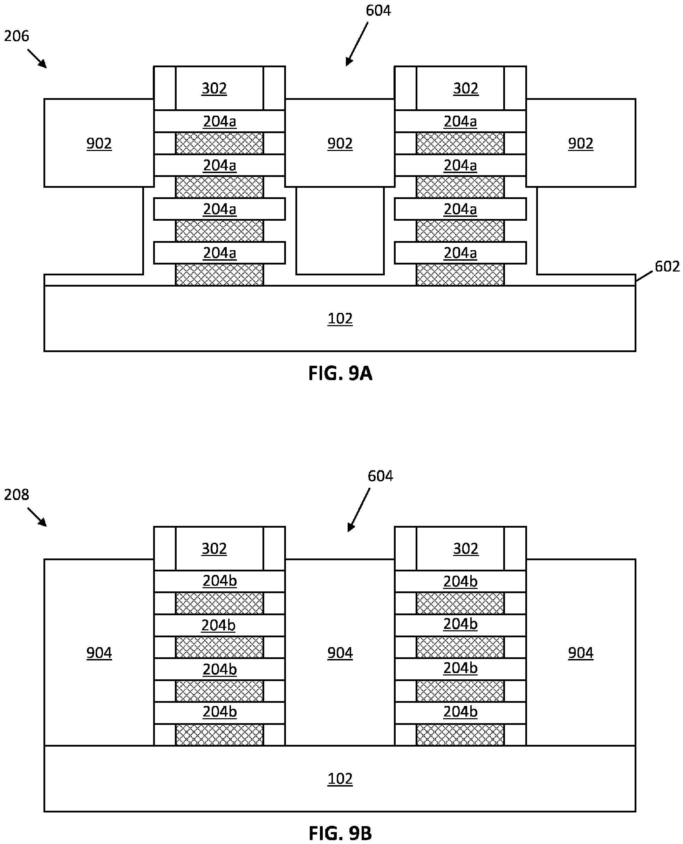

Figures 9A and 9B are cross-sectional views that illustrate another stage in the example process for forming an integrated circuit configured with one or more devices having source or drain regions in contact with only a subset of the total number of nanoribbons, in accordance with an embodiment of the present disclosure.

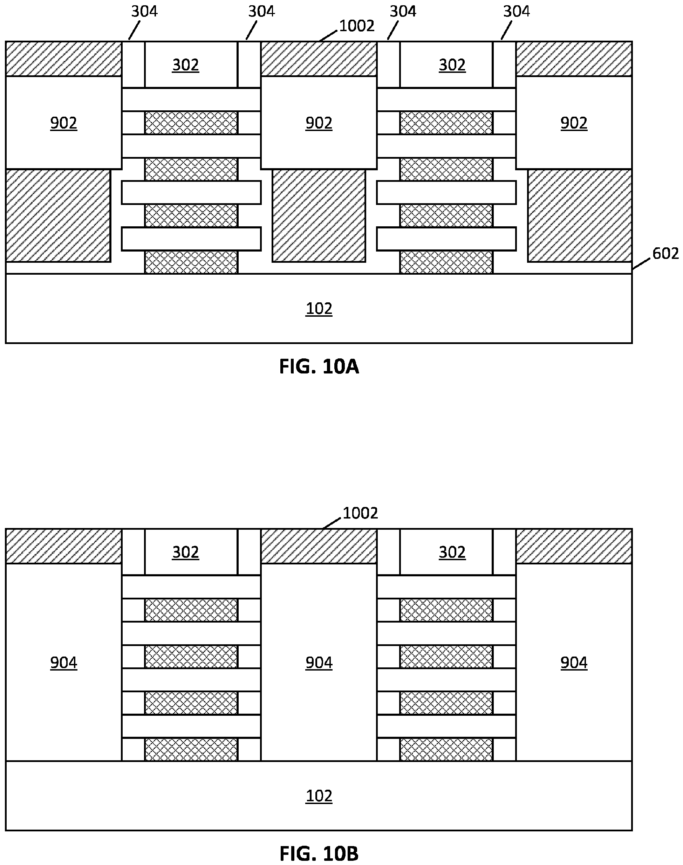

Figures 10A and 10B are cross-sectional views that illustrate another stage in the example process for forming an integrated circuit configured with one or more devices having source or drain regions in contact with only a subset of the total number of nanoribbons, in accordance with an embodiment of the present disclosure.

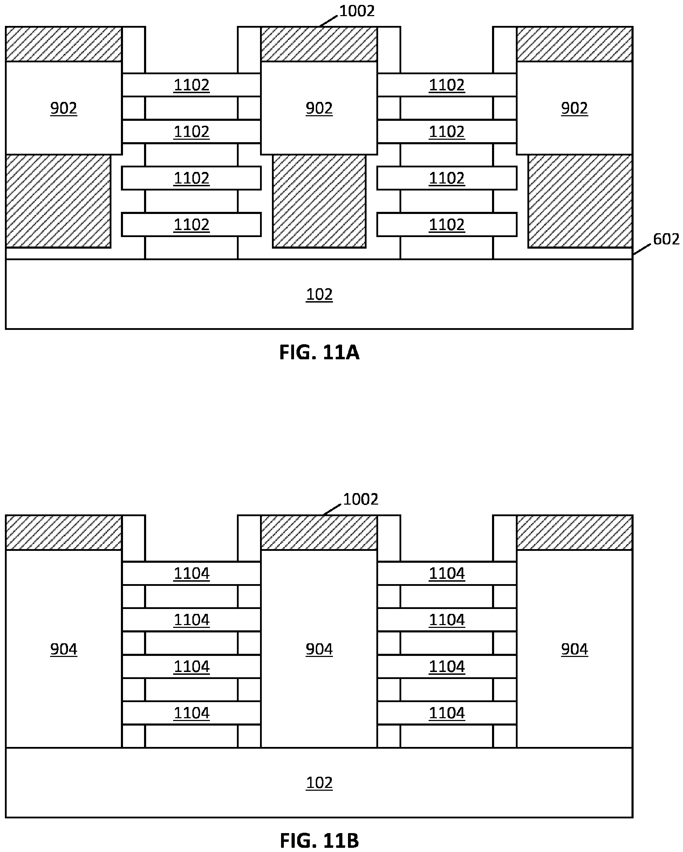

Figures 11A and 11B are cross-sectional views that illustrate another stage in the example process for forming an integrated circuit configured with one or more devices having source or drain regions in contact with only a subset of the total number of nanoribbons, in accordance with an embodiment of the present disclosure.

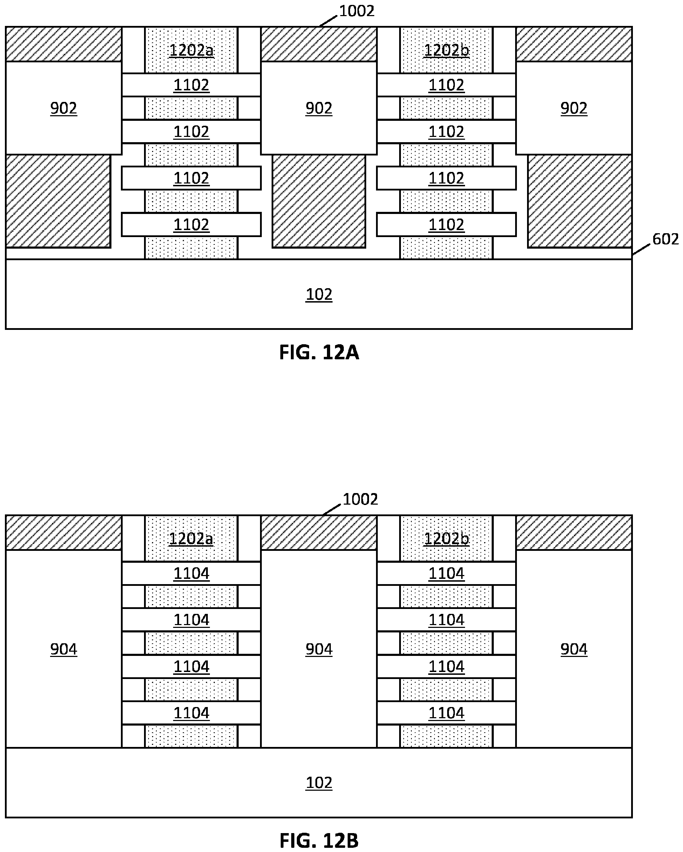

Figures 12A and 12B are cross-sectional views that illustrate another stage in the example process for forming an integrated circuit configured with one or more devices having source or drain regions in contact with only a subset of the total number of nanoribbons, in accordance with an embodiment of the present disclosure.

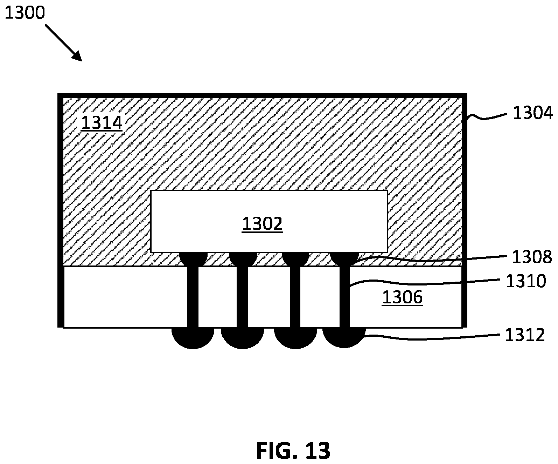

Figure 13 illustrates a cross-sectional view of a chip package containing one or more semiconductor dies, in accordance with some embodiments of the present disclosure.

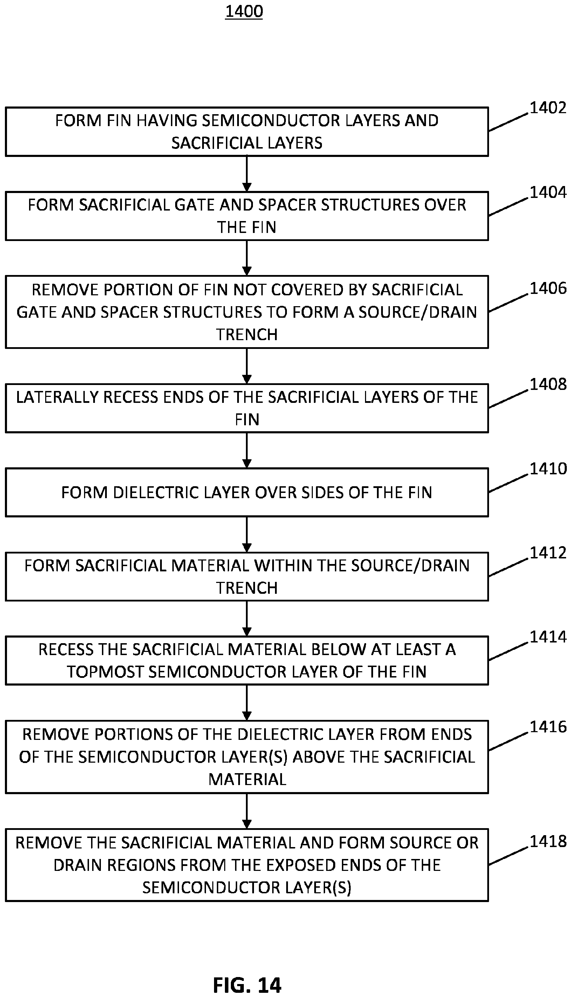

Figure 14 is a flowchart of a fabrication process for an integrated circuit having semiconductor devices with source or drain regions in contact with only a subset of the total number of nanoribbons, in accordance with an embodiment of the present disclosure.

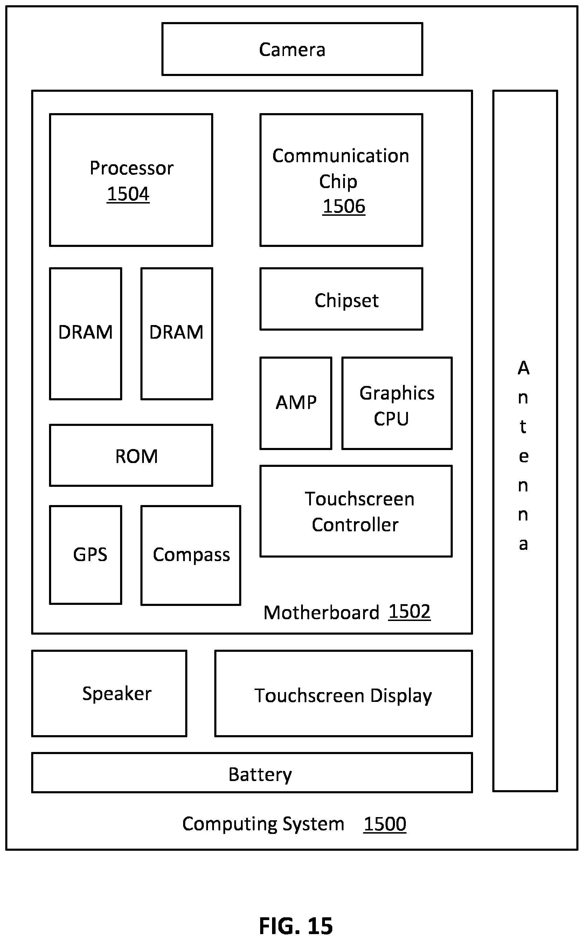

Figure 15 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices having only a subset of their total number of nanoribbons (or other such semiconductor bodies) active. The techniques can be used in any number of integrated circuit applications and are particularly useful with respect to gate-all-around (GAA) transistors (e.g., ribbonFETs and nanowire FETs) or forksheet transistors (e.g., nanosheets). In an example, any number of semiconductor devices includes a set of nanoribbons extending in a first direction and a gate structure extending in a second direction over each of the nanoribbons. Source or drain regions are formed at the ends of only a subset of the total number of nanoribbons, such that at least one of the nanoribbons does not contact the source or drain regions. In this way, the effective size of the device may be modulated based on how many nanoribbons are active (e.g., coupled to the source or drain regions). Advantageously, the techniques do not require depopulation processes within the channel region, which can be damaging to other exposed areas, particularly for relatively tall gate trenches. As used herein, a subset refers to any number that is less than the total number and greater than zero. Different numbers of nanoribbons or other semiconductor bodies may be active for different devices across the same substrate or die. Numerous variations and embodiments will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. GAA devices provide efficient use of limited chip footprint by providing several semiconductor regions (e.g., nanoribbons) in a single device. However, making changes to the geometry of certain structures across a given die can be challenging. For example, it may be beneficial for many applications to include transistors having different effective sizes (e.g., W/L ratio of the gate over the channel region). In the case of GAA devices, the size of the device is affected by various factors, such as the gate length, nanoribbon width, and number of nanoribbons. Some circuits, like memory circuits, may benefit from transistors having a different size compared to other circuits, like logic circuits. Additionally, p-type transistors (PMOS) may benefit from having a generally smaller W/L ratio compared to n-type transistors (NMOS). Changing the effective sizes of transistors across the same substrate or die is challenging, with added complexity and cost when designing densely packed devices. For instance, one possible solution is to remove or trim or depopulate portions of a given channel region by way of the gate trench, during gate processing, using an etch process. However, such processes can be damaging to other exposed areas and cause yield problems, despite any etch selectivity utilized.

Thus, and in accordance with an embodiment of the present disclosure, techniques are provided herein to form GAA semiconductor devices that utilize only a subset of the total number of nanoribbons present. In an example, one or more GAA devices each includes a number of nanoribbons extending along a first direction and a gate structure around each of the nanoribbons and extending over the nanoribbons in a second direction substantially orthogonal to the first direction. Epitaxial source and drain regions are formed that contact the ends of each of the nanoribbons. According to an embodiment, source or drain regions are formed at the ends of only a subset of the total number of nanoribbons. For example, if a given GAA device includes a gate structure around four nanoribbons, the source or drain regions may contact the ends of only 3 of the nanoribbons, only 2 of the nanoribbons, or only 1 of the nanoribbons. No active channels are formed within the nanoribbons that do not contact the source or drain regions, according to some embodiments. The active subset of nanoribbons may be chosen starting from the top of the nanoribbons and working downwards, such that the topmost nanoribbon is always used within any subset size.

According to some embodiments, a sacrificial material (e.g., ashable hardmask) is used to block off part of the source/drain trench prior to removing dielectric material that covers the ends of the nanoribbons. The height of the sacrificial material can be used to dictate how many of the lower nanoribbons remain blocked by the dielectric material. Accordingly, the source or drain regions ultimately grow from, or are formed on, only those nanoribbons that have the dielectric material removed from their ends. This technique may be used across a same substrate or die to modulate the number of active nanoribbons for any number of devices. Furthermore, different GAA devices on the same substrate or die can include a different number of active nanoribbons, but the same number of total nanoribbons. A similar technique can be used in forming forksheet devices, or other devices that can be configured with selectively exposable channel region ends from which source and drain regions can be grown.

According to an embodiment, an integrated circuit includes a semiconductor device with semiconductor nanoribbons extending in a first direction and a gate structure extending in a second direction over the semiconductor nanoribbons, and a source or drain region at the ends of only a first subset of the semiconductor nanoribbons such that a second subset of the semiconductor nanoribbons do not contact the source or drain region. In other such examples, the semiconductor nanoribbons may be semiconductor nanowires or semiconductor nanosheets, or other semiconductor bodies that reside within an overall channel region under the gate structure such that one or more of those bodies can be electrically isolated from the source and drain regions so as to not meaningfully participate in an active channel region.

According to another embodiment, an integrated circuit includes a first semiconductor device having first semiconductor nanoribbons extending in a first direction, a first gate structure extending in a second direction over the first semiconductor nanoribbons, and a first source or drain region at ends of the first semiconductor nanoribbons, and a second semiconductor device having second semiconductor nanoribbons extending in the first direction, a second gate structure extending in a second direction over the second semiconductor nanoribbons, and a second source or drain region at ends of only a first subset of the second semiconductor nanoribbons. A second subset of the second semiconductor nanoribbons does not contact the second source or drain region. Other semiconductor bodies may be used.

According to another embodiment, an integrated circuit includes a first semiconductor body and a second semiconductor body. Each of the first and second semiconductor bodies extends in a first direction with the first semiconductor body above the second semiconductor body. The first and second semiconductor bodies are each a nanowire, a nanoribbon, or a nanosheet. The integrated circuit further includes a gate structure extending in a second direction over the first and second semiconductor bodies, a source or drain region at an end of the first semiconductor body, and a dielectric fill beneath the source or drain region and laterally adjacent to the second semiconductor body. The second semiconductor body does not contact the source or drain region.

According to another embodiment, a method of forming an integrated circuit includes forming a fin comprising semiconductor layers, the fin extending above a substrate and lengthwise along a first direction; forming a dielectric layer over sides of the fin, the dielectric layer covering ends of the semiconductor layers; forming a sacrificial material within a recess directly adjacent to the dielectric layer; recessing the sacrificial material within the recess such that a top surface of the sacrificial material is below a first subset of the semiconductor layers and above a second subset of the semiconductor layers; removing the dielectric layer from the ends of the first subset of the semiconductor layers, such that the dielectric layer remains over the ends of the second subset of the semiconductor layers; removing the sacrificial material; and forming source or drain regions from the ends of only the first subset of the semiconductor layers.

The techniques can be used with any type of non-planar transistors, but are especially useful for nanowire and nanoribbon transistors (sometimes called GAA transistors) or nanosheet transistors (sometimes called forksheet transistors), to name a few examples. The source and drain regions can be, for example epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate one or more GAA or forksheet devices having source or drain regions that are contacting the ends of only a subset of the total number of nanoribbons, nanowires, or nanosheets present. A dielectric material (e.g., silicon nitride) may be observed covering the ends of those nanoribbons that do not contact the source or drain regions.

It should be readily understood that the meaning of "above" and "over" in the present disclosure should be interpreted in the broadest manner such that "above" and "over" not only mean "directly on" something but also include the meaning of over something with an intermediate feature or a layer therebetween. As used herein, the term "backside" generally refers to the area beneath one or more semiconductor devices (below the device layer) either within the device substrate or in the region of the device substrate (in the case where the bulk of the device substrate has been removed). Note that the backside may become a frontside, and vice-versa, if a given structure is flipped. To this end, and as will be appreciated, the use of terms like "above" "below" "beneath" "upper" "lower" "top" and "bottom" are used to facilitate discussion and are not intended to implicate a rigid structure or fixed orientation; rather such terms merely indicate spatial relationships when the structure is in a given orientation.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

Figure 1A is a cross-sectional view taken across a pair of first semiconductor devices 101 and Figure 1B is a cross-sectional view taken across a pair of second semiconductor devices 103, according to an embodiment of the present disclosure. Each of first and second semiconductor devices 101 and 103 may be gate-all-around (GAA) or forksheet transistor devices, although other transistor topologies and types could also benefit from the techniques provided herein. The illustrated embodiments herein use the GAA structure.

First and second semiconductor devices 101 and 103 together represent a portion of an integrated circuit that may contain any number of similar semiconductor devices. First and second semiconductor devices 101 and 103 could exist anywhere within the integrated circuit (on the same die) and may extend adjacent and parallel to one another along a first direction.

As can be seen, semiconductor devices 101 and 103 are formed on a same substrate 102 (or die). Any number of other semiconductor devices can be formed on substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, substrate 102 is removed from the backside and replaced with one or more dielectric layers along with conductive layers to form backside contacts and backside interconnect layers, such as a power delivery network.

First semiconductor devices 101 may include any number of semiconductor nanoribbons 104a while second semiconductor device 103 similarly may include any number of semiconductor nanoribbons 104b. Nanoribbons 104a may extend along a first direction (e.g., across the page). According to some embodiments, only a subset of nanoribbons 104a extend between (and contact) source or drain regions 106 along the first direction. In contrast, each of nanoribbons 104b may extend between source or drain regions 108 along the first direction. In the illustrated embodiment, only the top two of the four total nanoribbons 104a form part of the active channel between source or drain regions 106. The bottom two nanoribbons of the four total nanoribbons 104a do not contact source or drain regions 106, and therefore do not meaningfully participate in any active channel region that may form when the integrated circuit is powered. Rather, the bottom two nanoribbons have ends that terminate at a dielectric material, such as a dielectric fill 109. Dielectric fill 109 may be any suitable dielectric material, such as silicon dioxide, silicon nitride, or silicon oxynitride. According to some embodiments, dielectric fill 109 is formed within a portion of the source/drain trench beneath source or drain regions 106, such that dielectric fill 109 contacts a bottom surface of source or drain regions 106. Dielectric fill 109 may also extend up the sides of source or drain regions 106 within the source/drain trench (not seen in this cross-section).

Any source region may also act as a drain region and vice versa, depending on the application. Nanoribbons 104a and 104b can also be nanowires or nanosheets or other such semiconductor bodies and may have any number of geometries, such as circular, square, rectangular, or pancake-like (rectangular shape that is elongated into and out of page and relatively short up and down the page).

In some embodiments, semiconductor devices 101 and 103 have an equal number of nanoribbons. However, semiconductor devices 101 and 103 may have an unequal number of active nanoribbons that contact source or drain regions. For example, semiconductor devices 101 have only two of the four total nanoribbons 104a that contact source or drain regions 106 and thus the active channel forms only across the top two nanoribbons during the operation of semiconductor devices 101. In contrast, semiconductor devices 103 have all four nanoribbons 104b that contact source or drain regions 108 and thus the active channel forms across all nanoribbons 104b during the operation of semiconductor devices 103. This difference in the number of active nanoribbons changes the effective size between semiconductor devices 101 and 103 even though the devices both include the same total number of nanoribbons.

In some embodiments, each of nanoribbons 104a and nanoribbons 104b are formed from a fin of alternating material layers (e.g., alternating layers of silicon and silicon germanium) where sacrificial material layers are removed between nanoribbons 104a and nanoribbons 104b. In other embodiments, each of nanoribbons 104a and nanoribbons 104b may include the same semiconductor material as substrate 102, or another material layered on top of substrate 102. In still other cases, substrate 102 is removed. In some such example cases, there may be, for example one or more backside interconnect and/or contact layers.

According to some embodiments, source or drain regions 106/108 are epitaxial regions that are provided using an etch-and-replace process. Any semiconductor materials suitable for source and drain regions can be used (e.g., group IV and group III-V semiconductor materials). The source or drain regions may include multiple layers such as liners and capping layers to improve contact resistance and/or adhesion. In any such cases, the composition and doping of the source or drain regions 106/108 may be the same or different, depending on factors such as the polarity of the transistors and the given circuit application. Any number of source and drain configurations and materials can be used. In some examples, source or drain regions 106 represent p-type source or drain regions (e.g., silicon germanium doped with boron) while source or drain regions 108 represent n-type source or drain regions (e.g., silicon doped with phosphorous), or vice versa.

According to some embodiments, the fin structures include alternating layers of material (e.g., alternating layers of silicon and silicon germanium (SiGe)) that facilitates forming of nanoribbons (or nanowires or nanosheets, as the case may be) during a gate forming process where one type of the alternating layers is selectively etched away so as to liberate the other type of alternating layers within the channel region, so that a gate-all-around (GAA) process flow can then be carried out. In other examples, a forksheet process flow may be used, and the techniques described herein can also be beneficially applied to that process flow to provide modulated numbers of active nanosheets, as further described below. The alternating layers can be blanket deposited and then etched into fin structures or deposited into fin-shaped trenches.

According to some embodiments, a first gate structure 110a extends along a second direction into and out of the page over a first set of nanoribbons 104a and a first set of nanoribbons 104b. Similarly, a second gate structure 110b extends along the second direction over a second set of nanoribbons 104a and a second set of nanoribbons 104b. The second direction may be substantially orthogonal (e.g., 90 degrees, plus or minus a degree or two) to the first direction. According to some embodiments, each of the first and second gate structures 110a/110b includes a gate dielectric and a gate electrode. The gate dielectric may include any suitable dielectric material such as silicon dioxide and/or hafnium oxide. In some examples, the gate dielectric includes high-k material having a dielectric constant greater than 6.5. Some example high-k materials include hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

According to some embodiments, the gate electrodes of first and second gate structures 110a/110b may include any sufficiently conductive material such as a metal or metal alloy (e.g., tungsten or tungsten nitride), or polysilicon. According to some embodiments, the gate electrodes may be interrupted between any other semiconductor devices by a gate cut structure, such that gate structure 110a of Figure 1A is not coupled to gate structure 110a of Figure 1B and/or gate structure 110b of Figure 1A is not coupled to gate structure 110b of Figure 1B. In some embodiments, the gate electrodes include one or more work function metals on the gate dielectric and around the corresponding nanoribbons. For example, a p-channel device may include a work function metal having titanium on the gate dielectric and around the nanoribbons of the p-channel device. In another example, an n-channel device may include a work function metal having tungsten on the gate dielectric and around nanoribbons of the n-channel device. In some embodiments, the gate electrodes each includes a fill metal or other conductive material on the work function metal(s) to provide the whole gate electrode structure.

A conductive contact 112 may be formed over any of source or drain regions 106/108 to provide electrical connections to the corresponding source or drain regions. Conductive contact 112 can include any suitable conductive material, such as tungsten, copper, cobalt, titanium, ruthenium, tantalum, or molybdenum, or alloys of any of these. Contacts 112 may also include multiple layers, such as barrier and/or liner layers to inhibit electromigration and/or improve adhesion and contact resistance (e.g., layer of tantalum, titanium, or nitrides of same).

According to some embodiments, gate spacer structures 114 are present on sidewalls of gate structures 110a/110b to separate the gate structures from the source/drain trenches. Accordingly, gate spacer structures 114 extend along the second direction with gate structures 110a/110b. Gate spacer structures 114 may include any suitable dielectric material, such as silicon nitride or silicon oxynitride, and may include multiple layers such as a first layer of silicon nitride and a second layer of silicon dioxide on the layer of silicon nitride. Inner spacers 116 may also be used to separate the gate structures from the source/drain trenches between the nanoribbons. Accordingly, inner spacers 116 may be provided around the ends of nanoribbons 104a and 104b. Inner spacers 116 may include the same dielectric material as gate spacer structures 114 or may include any other suitable dielectric material.

Figure 1C provides a plan view of a portion of the integrated circuit taken across a given layer of nanoribbons 104a/104b. The cross-section of Figure 1A is taken across the 1A dashed line and the cross-section of Figure 1B is taken across the 1B dashed line. As shown is this example of Figure 1C, source or drain regions 106 and source or drain regions 108 may be provided within the same source/drain trench even though they may have different thicknesses to contact a different total number of nanoribbons.

According to some embodiments, dielectric fill 109 is present along the source/drain trench (e.g., extending along the second direction) between source or drain regions 106/108. Dielectric fill 109 may also extend beneath source or drain regions 106 as illustrated in Figure 1A. Dielectric fill 109 may also extend over any of source or drain regions 106/108 in locations where a topside contact is not made to the underlying source or drain region 106/108. In some embodiments, one or more gate cut structures may extend along the first direction between adjacent semiconductor devices to separate the gates of the adjacent semiconductor devices. Such gate cut structures can further extend across any number of gate trenches and source/drain trenches to separate any number of devices. In some examples, the gate cut structures are wide enough in the second direction to extend substantially the entire distance between adjacent source or drain regions.

### Fabrication Methodology

Figures 2A - 12A and 2B - 12B include cross-sectional views that collectively illustrate an example process for forming an integrated circuit having semiconductor devices with source or drain regions in contact with only a subset of the total number of nanoribbons, in accordance with an embodiment of the present disclosure. Figures 2A - 12A represent a similar cross-sectional view taken across a first set of semiconductor devices like those illustrated in Figure 1A, while Figures 2B - 12B represent a similar cross-sectional view taken across a second set of semiconductor devices like those illustrated in Figure 1B. Each set of figures sharing the same letter shows an example structure that results from the process flow up to that point in time, so the depicted structure evolves as the process flow continues, culminating in the structures shown in Figures 12A and 12B, which is similar to the structures shown in Figures 1A and 1B, respectively. Such structures may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. The process described herein in Figures 2-12 may be repeated any number of times for any number of semiconductor devices to form devices with differing numbers of active nanoribbons.

Figures 2A and 2B each illustrates a cross-sectional view taken through substrate 102 having a series of material layers formed over the substrate, according to an embodiment of the present disclosure. Alternating material layers may be deposited over substrate 102 including sacrificial layers 202 alternating with semiconductor layers 204a/204b. The alternating layers are used to form GAA transistor structures. Any number of alternating sacrificial layers 202 and semiconductor layers 204a/204b may be deposited over substrate 102. It should be noted that the cross-sections illustrated in Figures 2A and 2B are taken along the length of a first fin 206 with semiconductor layers 204a parallel to a second fin 208 with semiconductor layers 204b that each extend up above the surface of substrate 102.

According to some embodiments, semiconductor layers 204a/204b have a different material composition than sacrificial layers 202. In some embodiments, semiconductor layers 204a/204b are silicon germanium (SiGe) while sacrificial layers 202 include a semiconductor material suitable for use as a nanoribbon such as silicon (Si), SiGe, germanium, or III-V materials like indium phosphide (InP) or gallium arsenide (GaAs). In examples where SiGe is used in each of semiconductor layers 204a/204b and in sacrificial layers 202, the germanium concentration is different between semiconductor layers 204a/204b and sacrificial layers 202. For example, semiconductor layers 204a/204b may include a higher germanium content compared to sacrificial layers 202. In some examples, sacrificial layers 202 may be doped with either n-type dopants (to produce a p-channel transistor) or p-type dopants (to produce an n-channel transistor).

While dimensions can vary from one example embodiment to the next, the thickness of each semiconductor layer 204a/204b may be between about 5 nm and about 20 nm. In some embodiments, the thickness of each semiconductor layer 204a/204b is substantially the same (e.g., within 1-2 nm). The thickness of each of sacrificial layers 202 may be about the same as the thickness of each semiconductor layer 204a/204b (e.g., about 5-20 nm). Each of semiconductor layers 204a/204b and sacrificial layers 202 may be deposited using any known material deposition technique, such as chemical vapor deposition (CVD), plasma-enhanced chemical vapor deposition (PECVD), physical vapor deposition (PVD), or atomic layer deposition (ALD), or epitaxial growth.

Figures 3A and 3B depict the cross-section views of the structure shown in Figures 2A and 2B, respectively, following the formation of sacrificial gate structures 302 and spacer structures 304 over the alternating layer structure of the fins, according to an embodiment. Sacrificial gate structures 302 may run in an orthogonal direction (e.g., along a second direction) to the length of the fins and may include any material that can be safely removed later in the process without etching or otherwise damaging any portions of the fins or of spacer structures 304. In some embodiments, sacrificial gate structures 302 include polysilicon. Spacer structures 304 may be formed using an etch-back process where spacer material is deposited everywhere and then anisotropically etched to leave the material only on sidewalls of structures including sacrificial gate structures 302. Spacer structures 304 may include a dielectric material, such as silicon nitride, silicon oxy-nitride, or any formulation of those layers incorporating carbon or boron dopants. Sacrificial gate structures 302 together with spacer structures 304 define portions of the fin that will be used to form first and second semiconductor devices, as discussed further herein.

Figures 4A and 4B depict cross-section views of the structure shown in Figures 3A and 3B, respectively, following the removal of the exposed portions of first fin 206 and second fin 208 not under sacrificial gate structures 302 and spacer structures 304, according to an embodiment of the present disclosure. According to some embodiments, the various alternating material layers are etched together using an anisotropic RIE process. In some embodiments, some undercutting occurs along the edges of the resulting fin structures beneath spacer structures 304 such that the length of a given fin structure is not exactly the same as a sum of the widths of spacer structures 304 and a width of sacrificial gate structure 302. The RIE process may also etch into substrate 102 thus recessing portions of substrate 102 on either side of any of the fin structures. The portion of 102 under a given fin structure may be referred to as a subfin.

Figures 5A and 5B depict cross-section views of the structure shown in Figures 4A and 4B, respectively, following the removal of portions of sacrificial layers 202, according to an embodiment of the present disclosure. A selective and timed isotropic etching process may be used to recess the exposed ends of each sacrificial layers 202. The etch is selective to semiconductor layers 204 and spacer structures 304 to largely remove only the material of sacrificial layers 202. The amount of recessing of sacrificial layers 202 dictates the width of the inner spacer structures that will be formed within the lateral cavities. To this end, the dwell time of the recess etch can be set to provide a desired recess depth. In the illustrated example, sacrificial layers 202 have been recessed to a lateral depth that is substantially similar to a width of spacer structures 304 along the first direction.

Figures 6A and 6B depict cross-section views of the structure shown in Figures 5A and 5B, respectively, following the formation of a dielectric layer 602 over the entire structure and along all exposed surfaces within a source/drain trench 604, according to an embodiment of the present disclosure. Dielectric layer 602 may have a material composition that is similar to or the exact same as spacer structures 304. According to some embodiments, dielectric layer 602 is conformally deposited on all exposed surfaces using, for example, atomic layer deposition (ALD). Dielectric layer 602 may substantially fill the lateral recesses near the ends of semiconductor layers 204a/204b and also forms over the ends of semiconductor layers 204a/204b within source/drain trench 604.

Figures 7A and 7B depict cross-section views of the structure shown in Figures 6A and 6B, respectively, following the formation of a sacrificial material 702 within source/drain trench 604, according to an embodiment of the present disclosure. Sacrificial material 702 may be deposited within source/drain trench 604, masked off, and subsequently patterned such that it remains only within the portion of source/drain trench 604 adjacent to fin 206 (e.g., is removed from source/drain trench 604 adjacent to fin 208). Furthermore, sacrificial material 702 may be recessed within source/drain trench 604 such that the top surface of sacrificial material 702 is between any two of the semiconductor layers 204a. In the illustrated example, sacrificial material 702 has been recessed to the point where its top surface is between the 2^{nd} and 3^{rd} semiconductor layers 204a from the bottom. Accordingly, sacrificial material 702 remains in a bottom portion of source/drain trench 604 adjacent to the bottom two semiconductor layers 204a along the first direction and is not adjacent to the top two semiconductor layers 204a along the first direction. The presence of sacrificial material 702 will block the growth of source or drain regions, and thus the number of semiconductor layers 204a that are not adjacent to sacrificial material 702 along the first direction correspond to the number of active nanoribbons for that device. In an example, if sacrificial material 702 had been recessed further such that its top surface was between the 1^{st} and 2^{nd} semiconductor layers 204a from the bottom, then the top three semiconductor layers 204 would ultimately become the three active nanoribbons of the device. Note that the complete removal of sacrificial material 702 from source/drain trench 604 around fin 208 means that all nanoribbons will be active for the devices from fin 208, according to some embodiments. Any number of semiconductor layers 204a can be chosen in this way to modulate the final number of active nanoribbons for the device.

Sacrificial material 702 may be any suitable material that can be deposited and etched without damaging surrounding structures. In one example, sacrificial material 702 is carbon hard mask (CHM) and is deposited using any suitable chemical vapor deposition (CVD) technique. In some other examples, sacrificial material 702 is aluminum oxide. Sacrificial material 702 may be recessed using any suitable isotropic etching process.

Figures 8A and 8B depict cross-section views of the structure shown in Figures 7A and 7B, respectively, following etching back of any portions of dielectric layer 602 not protected by sacrificial material 702, according to an embodiment of the present disclosure. Dielectric layer 602 may be etched such that it remains within the lateral recesses near the ends of semiconductor layers 204a/204b, thus forming inner spacers 802 within these recesses. However, the presence of sacrificial material 702 at fin 206 causes dielectric layer 602 to remain along the bottom of source/drain trench 604 and also along the ends of a bottom subset of the semiconductor layers 204a of fin 206, according to some embodiments. A top subset of semiconductor layers 204a above the top surface of sacrificial material 702 have their ends exposed during the etching back of dielectric layer 602.

Figures 9A and 9B depict cross-section views of the structure shown in Figures 8A and 8B, respectively, following the growth of first source or drain regions 902 along fin 206 and second source or drain regions 904 along fin 208, according to an embodiment of the present disclosure. Prior to the growth of source or drain regions 902/904, sacrificial material 702 may be removed using any suitable isotropic etching process or ashing process. First source or drain regions 902 may be epitaxially grown from the exposed ends of the first subset of semiconductor layers 204a, according to some embodiments. As noted above, the ends of the second subset of semiconductor layers 204a are covered by dielectric layer 602, and thus no epitaxial growth occurs from these ends. As a result, first source or drain regions 902 grow across source/drain trench 604 along the first direction between only the first subset of semiconductor layers 204a.

According to some embodiments, second source or drain regions 904 are grown from the exposed ends of semiconductor layers 204b of fin 208 at the same time as first source or drain regions 902. In other examples, first source or drain regions 902 and second source or drain regions 904 are grown at different times by masking off the devices where growth is not desired. Since the ends of all semiconductor layers 204b are exposed within source/drain trench 604, second source or drain regions 904 may grow along substantially the entire height of fin 208.

As noted above, any of first source or drain regions 902 or second source or drain regions 904 can act as either a source or drain depending on the application. Any semiconductor materials suitable for the source or drain regions 902/904 can be used (e.g., group IV and group III-V semiconductor materials). Source or drain regions 902/904 may include multiple layers such as liners and capping layers to improve contact resistance. In some examples, first source or drain regions 902 may be p-type regions while second source or drain regions 904 may be n-type regions. Any number of source or drain configurations and materials can be used.

Figures 10A and 10B depict cross-section views of the structure shown in Figures 9A and 9B, respectively, following the formation of a dielectric fill 1002 within any remaining portion of the source/drain trench 604, according to an embodiment of the present disclosure. Dielectric fill 1002 may be any suitable dielectric material, such as silicon dioxide. According to some embodiments, dielectric fill 1002 extends along the second direction within the source/drain trench 604 between any adjacent source or drain regions, such as between first source or drain region 902 and second source or drain region 904. Dielectric fill 1002 may also be formed beneath first source or drain region 902 such that dielectric fill 1002 contacts a bottom surface of first source or drain region 902. According to some embodiments, a top surface of dielectric fill 1002 is polished such that it is substantially coplanar with a top surface of sacrificial gate structure 302 and/or spacer structures 304. As such, dielectric fill 1002 may also form over the top surfaces of both first source or drain region 902 and second source or drain region 904 within the source/drain trench 604. Any of the top portions of dielectric fill 1002 above any number of source or drain regions may be removed and replaced with a conductive contact to make electrical connection to the underlying source or drain regions.

Figures 11A and 11B depict cross-section views of the structure shown in Figures 10A and 10B, respectively, following the removal of sacrificial gate structures 302 and sacrificial layers 202, according to some embodiments. In examples where any gate masking layers are still present, they would be removed at this time. Once sacrificial gate structures 302 are removed, the fins extending along the first direction within the gate trench are exposed.

In the example where the fins include alternating semiconductor layers, sacrificial layers 202 are selectively removed to leave behind nanoribbons 1102 that extend along the first direction and nanoribbons 1104 that extend along the first direction. As discussed above, only a subset of nanoribbons 1102 (e.g., 1-3 nanoribbons from the top on down) extend between, and contact, first source or drain region 902, while each of nanoribbons 1104 extends between and contacts second source or drain region 904. Accordingly, the subset of nanoribbons 1102 that do not contact first source or drain region 902 are inactive. Each vertical set of nanoribbons 1102/1104 represents the semiconductor region (or channel region) of a different semiconductor device. Recall from above that nanoribbons 1102/1104 may also be nanowires or nanosheets. Sacrificial gate structures 302 and sacrificial layers 202 may be removed using the same isotropic etching process or different isotropic etching processes.

Figures 12A and 12B depict cross-section views of the structure shown in Figures 11A and 11B, respectively, following the formation of gate structures 1202a and 1202b, according to some embodiments. Each of the gate structures 1202a/1202b includes a gate dielectric and a gate electrode on the gate dielectric. The gate dielectric may be first formed around nanoribbons 1102/1104 prior to the formation of the gate electrode, which may include one or more conductive layers. The gate dielectric may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric includes a layer of hafnium oxide with a thickness between about 1 nm and about 5 nm. In some embodiments, the gate dielectric may include one or more silicates (e.g., titanium silicate, tungsten silicate, niobium silicate, and silicates of other transition metals). In some cases, the gate dielectric includes a first layer on nanoribbons 1102/1104, and a second layer on the first layer. The first layer can be, for instance, an oxide of the semiconductor material of nanoribbons 1102/1104 (e.g., silicon dioxide) and the second layer can be a high-k dielectric material (e.g., hafnium oxide). In some embodiments, the gate dielectric may also be deposited and left on the gate-side facing surfaces of inner spacers 802, and on gate-side facing surfaces of spacer structures 304, and on the bottom of the gate trench on substrate 102. The gate dielectric may be, for instance, conformally deposited using CVD or ALD.

The one or more conductive layers that make up the gate electrode may be deposited using electroplating, electroless plating, CVD, PECVD, ALD, or PVD, to name a few examples. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Note that for nanoribbons 1102, gate structures 1202a and 1202b are formed around all nanoribbons, including the inactive subset of nanoribbons beneath the active subset of nanoribbons.

Figure 13 illustrates an example embodiment of a chip package 1300, in accordance with an embodiment of the present disclosure. As can be seen, chip package 1300 includes one or more dies 1302. One or more dies 1302 may include at least one integrated circuit having semiconductor devices, such as any of the semiconductor devices disclosed herein. One or more dies 1302 may include any other circuitry used to interface with other devices formed on the dies, or other devices connected to chip package 1300, in some example configurations.

As can be further seen, chip package 1300 includes a housing 1304 that is bonded to a package substrate 1306. The housing 1304 may be any standard or proprietary housing, and may provide, for example, electromagnetic shielding and environmental protection for the components of chip package 1300. The one or more dies 1302 may be conductively coupled to a package substrate 1306 using connections 1308, which may be implemented with any number of standard or proprietary connection mechanisms, such as solder bumps, ball grid array (BGA), pins, or wire bonds, to name a few examples. Package substrate 1306 may be any standard or proprietary package substrate, but in some cases includes a dielectric material having conductive pathways (e.g., including conductive vias and lines) extending through the dielectric material between the faces of package substrate 1306, or between different locations on each face. In some embodiments, package substrate 1306 may have a thickness less than 1 millimeter (e.g., between 0.1 millimeters and 0.5 millimeters), although any number of package geometries can be used. Additional conductive contacts 1312 may be disposed at an opposite face of package substrate 1306 for conductively contacting, for instance, a printed circuit board (PCB). One or more vias 1310 extend through a thickness of package substrate 1306 to provide conductive pathways between one or more of connections 1308 to one or more of contacts 1312. Vias 1310 are illustrated as single straight columns through package substrate 1306 for ease of illustration, although other configurations can be used (e.g., damascene, dual damascene, through-silicon via, or an interconnect structure that meanders through the thickness of substrate 1306 to contact one or more intermediate locations therein). In still other embodiments, vias 1310 are fabricated by multiple smaller stacked vias, or are staggered at different locations across package substrate 1306. In the illustrated embodiment, contacts 1312 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1312, to inhibit shorting.

In some embodiments, a mold material 1314 may be disposed around the one or more dies 1302 included within housing 1304 (e.g., between dies 1302 and package substrate 1306 as an underfill material, as well as between dies 1302 and housing 1304 as an overfill material). Although the dimensions and qualities of the mold material 1314 can vary from one embodiment to the next, in some embodiments, a thickness of mold material 1314 is less than 1 millimeter. Example materials that may be used for mold material 1314 include epoxy mold materials, as suitable. In some cases, the mold material 1314 is thermally conductive, in addition to being electrically insulating.

### Methodology

Figure 14 is a flow chart of a method 1400 for forming at least a portion of an integrated circuit, according to an embodiment. Various operations of method 1400 may be illustrated in Figures 2A - 12A and 2B - 12B. However, the correlation of the various operations of method 1400 to the specific components illustrated in the aforementioned figures is not intended to imply any structural and/or use limitations. Rather, the aforementioned figures provide example embodiments of method 1400. Other operations may be performed before, during, or after any of the operations of method 1400. Some of the operations of method 1400 may be performed in a different order than the illustrated order.

Method 1400 begins with operation 1402 where at least one multilayer fin is formed having alternating semiconductor and sacrificial layers. The sacrificial layers may include SiGe while the semiconductor layers may be Si, SiGe, Ge, InP, or GaAs, to name a few examples. The thickness of each of the sacrificial and semiconductor layers may be between about 5 nm and about 20 nm or between about 5 nm and about 10 nm. Each of the sacrificial and semiconductor layers may be deposited using any known material deposition technique, such as CVD, PECVD, PVD, or ALD.

Method 1400 continues with operation 1404 where sacrificial gate and spacer structures are formed over the fin, according to some embodiments. The sacrificial gates may be patterned using gate masking layers in strips that run orthogonally over multiple parallel fins and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fin. In one example, the sacrificial gates include polysilicon.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fin running orthogonally between the strips of sacrificial gates. According to some embodiments, the spacer structures may include any suitable dielectric material, such as silicon nitride or silicon oxynitride, or any number of different dielectric layers.

Method 1400 continues with operation 1406 where portions of the fin are removed from between the sacrificial gates and spacer structures. According to some embodiments, the various alternating material layers of the fin are etched together using an anisotropic RIE process. The RIE process may also etch into the substrate thus recessing portions of the substrate on either side of the fin. The removal of the exposed fin portions creates a source/drain trench running along the second direction adjacent to the sacrificial gate and spacer structures.

Method 1400 continues with operation 1408 where an isotropic and selective etching process is performed to laterally the etch the exposed sacrificial layers of the fin to a given lateral depth. The amount of recessing of the sacrificial layers of the fin dictates the width of the inner spacer structures that will be formed. In some examples, the sacrificial layers may be recessed to a lateral depth that is substantially the same as a lateral width of the spacer structures.

Method 1400 continues with operation 1410 where a dielectric layer is formed over the exposed sides of the fin. According to some embodiments, the dielectric layer is deposited along all exposed surfaces within the source/drain trench such that it fills the lateral recesses created by recessing the sacrificial layers and also covers the exposed ends of the semiconductor layers of the fin. The dielectric layer may be any suitable dielectric material, such as silicon nitride or silicon oxynitride. In some examples, the dielectric layer is the same dielectric material as the spacer structures.

Method 1400 continues with operation 1412 where a sacrificial material is formed within the source/drain trench on the dielectric layer. The sacrificial material may be any suitable material that can be etched or removed without damaging surrounding structures and that also has a high etch selectivity with at least the dielectric layer. In some examples, the sacrificial material includes CHM or aluminum oxide.

Method 1400 continues with operation 1414 where the sacrificial material is recessed within the source/drain trench at least below a topmost semiconductor layer of the fin. The final height of the sacrificial material within the source/drain trench controls how many of the semiconductor layers will ultimately be used as active nanoribbons for the device. According to some embodiments, only those semiconductor layers above the top surface of the sacrificial material will become active nanoribbons that contact source or drain regions. If the sacrificial material is fully removed form the source/drain trench, then all semiconductor layers in the fin will become active nanoribbons in the final device. Any suitable isotropic etching process may be used to recess the sacrificial material to a final desired height.

Method 1400 continues with operation 1416, where portions of the dielectric layer on the ends of the semiconductor layer(s) above the sacrificial material are removed. The dielectric layer may be etched such that it remains within the lateral recesses near the ends of the semiconductor layers, thus forming inner spacers within these recesses. However, the presence of the sacrificial material within a bottom portion of the source/drain trench causes the dielectric layer to remain along the bottom of the source/drain trench and also along the ends of a bottom subset of the semiconductor layers, according to some embodiments. A top subset of the semiconductor layers above the top surface of the sacrificial material have their ends exposed during the etching back of the dielectric layer.

Method 1400 continues with operation 1418, where the sacrificial material is removed and source or drain regions are formed from the exposed ends of the semiconductor layers of the fin. Prior to the growth of source or drain regions, the sacrificial material is removed using any suitable isotropic etching process or ashing process, according to some embodiments. The source or drain regions may be epitaxially grown from the exposed ends of the first subset of the semiconductor layers, while a second subset of the semiconductor layers below the first subset are blocked from any epitaxial growth by the dielectric layer, according to some embodiments. As a result, the source or drain regions grow across the source/drain trench along the first direction between only the first subset of semiconductor layers.

### Example System

Figure 15 is an example computing system implemented with one or more of the integrated circuit structures as disclosed herein, in accordance with some embodiments of the present disclosure. As can be seen, the computing system 1500 houses a motherboard 1502. The motherboard 1502 may include a number of components, including, but not limited to, a processor 1504 and at least one communication chip 1506, each of which can be physically and electrically coupled to the motherboard 1502, or otherwise integrated therein. As will be appreciated, the motherboard 1502 may be, for example, any printed circuit board (PCB), whether a main board, a daughterboard mounted on a main board, or the only board of system 1500, etc.

Depending on its applications, computing system 1500 may include one or more other components that may or may not be physically and electrically coupled to the motherboard 1502. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1500 may include one or more integrated circuit structures or devices configured in accordance with an example embodiment (e.g., a module including an integrated circuit on a substrate, the substrate having GAA semiconductor devices with source or drain regions in contact with only a subset of the total number of nanoribbons, as variously provided herein). In some embodiments, multiple functions can be integrated into one or more chips (e.g., for instance, note that the communication chip 1506 can be part of or otherwise integrated into the processor 1504).

The communication chip 1506 enables wireless communications for the transfer of data to and from the computing system 1500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1506 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1500 may include a plurality of communication chips 1506. For instance, a first communication chip 1506 may be dedicated to shorter range wireless communications such as Wi-Fi and Bluetooth and a second communication chip 1506 may be dedicated to longer range wireless communications such as GPS, EDGE, GPRS, CDMA, WiMAX, LTE, Ev-DO, and others.

The processor 1504 of the computing system 1500 includes an integrated circuit die packaged within the processor 1504. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1506 also may include an integrated circuit die packaged within the communication chip 1506. In accordance with some such example embodiments, the integrated circuit die of the communication chip includes one or more semiconductor devices as variously described herein. As will be appreciated in light of this disclosure, note that multi-standard wireless capability may be integrated directly into the processor 1504 (e.g., where functionality of any chips 1506 is integrated into processor 1504, rather than having separate communication chips). Further note that processor 1504 may be a chip set having such wireless capability. In short, any number of processor 1504 and/or communication chips 1506 can be used. Likewise, any one chip or chip set can have multiple functions integrated therein.

In various implementations, the computing system 1500 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1500 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes semiconductor bodies extending in a first direction, a gate structure extending in a second direction over the semiconductor bodies, and a source or drain region at ends of only a first subset of the semiconductor bodies such that a second subset of the semiconductor bodies does not contact the source or drain region.

Example 2 includes the integrated circuit of Example 1, wherein the first subset of the semiconductor bodies comprises only a topmost body of the semiconductor bodies, only the top two bodies of the semiconductor bodies, or only the top three bodies of the semiconductor bodies.

Example 3 includes the integrated circuit of Example 1 or 2, further comprising a dielectric fill beneath the source or drain region and laterally adjacent to the second subset of the semiconductor bodies.

Example 4 includes the integrated circuit of any one of Examples 1-3, wherein the source or drain region is a first source or drain region and the integrated circuit further comprises a second source or drain region at opposite ends of only the first subset of the semiconductor bodies such that the second subset of the semiconductor bodies does not contact the second source or drain region.

Example 5 includes the integrated circuit of any one of Examples 1-4, further comprising a dielectric layer over the ends of the second subset of the semiconductor bodies.

Example 6 includes the integrated circuit of Example 5, wherein the dielectric layer comprises silicon and nitrogen.

Example 7 includes the integrated circuit of any one of Examples 1-6, wherein the semiconductor bodies are first semiconductor bodies, the integrated circuit further comprising a dielectric fill between the ends of the second subset of the first semiconductor bodies and laterally adjacent to ends of second semiconductor bodies, the second semiconductor bodies extending in the first direction.

Example 8 includes the integrated circuit of Example 7, wherein the gate structure is a first gate structure, and the source or drain region is a first source or drain region. The integrated circuit further includes a second gate structure extending in the second direction over the second semiconductor bodies, and a second source or drain region at ends of only a first subset of the second semiconductor bodies such that a second subset of the semiconductor bodies does not contact the second source or drain region.

Example 9 includes the integrated circuit of any one of Examples 1-8, further comprising a conductive contact on a top surface of the source or drain region.

Example 10 includes the integrated circuit of any one of Examples 1-9, further comprising a subfin below the semiconductor bodies.

Example 11 includes the integrated circuit of any one of Examples 1-10, wherein the first subset includes two or three semiconductor bodies, and the second subset includes one or two semiconductor bodies.

Example 12 includes the integrated circuit of any one of Examples 1-11, wherein the semiconductor bodies are semiconductor nanoribbons.

Example 13 includes the integrated circuit of any one of Examples 1-11, wherein the semiconductor bodies are semiconductor nanosheets.

Example 14 includes the integrated circuit of any one of Examples 1-13, wherein the semiconductor bodies, the gate structure, and the source or drain region are at least part of a gate-all-around transistor device or a forksheet transistor device.

Example 15 is a printed circuit board comprising the integrated circuit of any one of Examples 1-14.

Example 16 is an electronic device that includes a chip package having one or more dies. At least one of the one or more dies includes a plurality of semiconductor nanoribbons extending in a first direction, a gate structure extending in a second direction over the semiconductor nanoribbons, and a source or drain region at the ends of only a first subset of the semiconductor nanoribbons such that a second subset of the semiconductor nanoribbons do not contact the source or drain region.

Example 17 includes the electronic device of Example 16, wherein the first subset of the semiconductor nanoribbons comprises only the topmost nanoribbon of the semiconductor nanoribbons, only the top two nanoribbons of the semiconductor nanoribbons, or only the top three nanoribbons of the semiconductor nanoribbons.

Example 18 includes the electronic device of Example 16 or 17, wherein the at least one of the one or more dies further comprises a dielectric fill beneath the source or drain region and laterally adjacent to the second subset of the semiconductor nanoribbons.

Example 19 includes the electronic device of any one of Examples 16-18, wherein the source or drain region is a first source or drain region and the at least one of the one or more dies further comprises a second source or drain region at opposite ends of only the first subset of the semiconductor nanoribbons such that the second subset of the semiconductor nanoribbons does not contact the second source or drain region.

Example 20 includes the electronic device of any one of Examples 16-19, wherein the at least one of the one or more dies further comprises a dielectric layer over the ends of the second subset of the semiconductor nanoribbons.

Example 21 includes the electronic device of Example 20, wherein the dielectric layer comprises silicon and nitrogen.

Example 22 includes the electronic device of any one of Examples 16-21, wherein the at least one of the one or more dies further comprises a conductive contact on a top surface of the source or drain region.

Example 23 includes the electronic device of any one of Examples 16-22, further comprising a printed circuit board, wherein the chip package is coupled to the printed circuit board.

Example 24 is a method of forming an integrated circuit. The method includes forming a fin comprising semiconductor layers, the fin extending above a substrate and lengthwise along a first direction, forming a dielectric layer over sides of the fin, the dielectric layer covering ends of the semiconductor layers, forming a sacrificial material within a recess directly adjacent to the dielectric layer, recessing the sacrificial material within the recess such that a top surface of the sacrificial material is below a first subset of the semiconductor layers and above a second subset of the semiconductor layers, removing the dielectric layer from the ends of the first subset of the semiconductor layers, such that the dielectric layer remains over the ends of the second subset of the semiconductor layers, removing the sacrificial material, and forming source or drain regions from the ends of only the first subset of the semiconductor layers.

Example 25 includes the method of Example 24, wherein the sacrificial material comprises carbon hard mask (CHM).

Example 26 includes the method of Example 24 or 25, wherein the first subset of the semiconductor layers includes only one, only two, or only three semiconductor layers.

Example 27 includes the method of any one of Examples 24-26, further comprising forming a dielectric fill on the top and bottom surfaces of the source or drain regions.

Example 28 is an integrated circuit that includes a first semiconductor device having first semiconductor nanoribbons extending in a first direction, a first gate structure extending in a second direction over the first semiconductor nanoribbons, and a first source or drain region at ends of each of the first semiconductor nanoribbons. The integrated circuit also includes a second semiconductor device having second semiconductor nanoribbons extending in the first direction, a second gate structure extending in a second direction over the second semiconductor nanoribbons, and a second source or drain region at ends of only a first subset of the second semiconductor nanoribbons such that a second subset of the second semiconductor nanoribbons does not contact the second source or drain region.

Example 29 includes the integrated circuit of Example 28, wherein the first subset of the second semiconductor nanoribbons comprises only the topmost nanoribbon of the second semiconductor nanoribbons, only the top two nanoribbons of the second semiconductor nanoribbons, or only the top three nanoribbons of the second semiconductor nanoribbons.

Example 30 includes the integrated circuit of Example 28 or 29, further comprising a dielectric fill beneath the second source or drain region and laterally adjacent to the second subset of the second semiconductor nanoribbons.

Example 31 includes the integrated circuit of any one of Examples 28-30, wherein the second semiconductor device further comprises a third source or drain region at opposite ends of only the first subset of the second semiconductor nanoribbons such that the second subset of the second semiconductor nanoribbons do not contact the third source or drain region.

Example 32 includes the integrated circuit of any one of Examples 28-31, further comprising a dielectric layer over the ends of the second subset of the second semiconductor nanoribbons.

Example 33 includes the integrated circuit of Example 32, wherein the dielectric layer comprises silicon and nitrogen.

Example 34 includes the integrated circuit of any one of Examples 28-33, further comprising a first conductive contact on a top surface of the first source or drain region and a second conductive contact on a top surface of the second source or drain region.

Example 35 includes the integrated circuit of any one of Examples 28-34, wherein a total number of the first semiconductor nanoribbons contacting the first source or drain region is different from a total number of the second semiconductor nanoribbons contacting the second source or drain region.

Example 36 is a printed circuit board comprising the integrated circuit of any one of Examples 28-35.

Example 37 is an integrated circuit that includes a first semiconductor body and a second semiconductor body, each extending in a first direction, a gate structure extending in a second direction over the first and second semiconductor bodies, a source or drain region at an end of the first semiconductor body, and a dielectric fill beneath the source or drain region and laterally adjacent to the second semiconductor body. The first semiconductor body is above the second semiconductor body. The first and second semiconductor bodies are each a nanowire, a nanoribbon, or a nanosheet. The second semiconductor body does not contact the source or drain region.

Example 38 includes the integrated circuit of Example 37, further comprising a third semiconductor body extending in the first direction, the third semiconductor body above the second semiconductor body, wherein an end of the third semiconductor body contacts the source or drain region.

Example 39 includes the integrated circuit of Example 37, wherein the gate structure is a first gate structure, and the source or drain region is a first source or drain region. The integrated circuit further comprises a third semiconductor body and fourth semiconductor body, each extending in the first direction, a second gate structure extending in the second direction over the third and fourth semiconductor bodies, and a second source or drain region at ends the third and fourth semiconductor bodies. The third semiconductor body is above the fourth semiconductor body. The third and fourth semiconductor bodies are each a nanowire, a nanoribbon, or a nanosheet.

Example 40 includes the integrated circuit of any one of Examples 37-39, further comprising a conductive contact on a top surface of the source or drain region.

Example 41 includes the integrated circuit of any one of Examples 37-40, further comprising a subfin below the first and second semiconductor bodies.

Example 42 includes the integrated circuit of any one of Examples 37-41, wherein the first and second semiconductor bodies, the gate structure, and the source or drain region are at least part of a gate-all-around transistor device or a forksheet transistor device.

Example 43 is a printed circuit board comprising the integrated circuit of any one of Examples 37-42.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
semiconductor bodies extending in a first direction;
a gate structure extending in a second direction over the semiconductor bodies; and
a source or drain region at ends of only a first subset of the semiconductor bodies such that a second subset of the semiconductor bodies does not contact the source or drain region.

2. The integrated circuit of claim 1, wherein the first subset of the semiconductor bodies comprises only a topmost body of the semiconductor bodies, only the top two bodies of the semiconductor bodies, or only the top three bodies of the semiconductor bodies.

3. The integrated circuit of claim 1 or 2, further comprising a dielectric fill beneath the source or drain region and laterally adjacent to the second subset of the semiconductor bodies.

4. The integrated circuit of any one of claims 1 through 3, wherein the source or drain region is a first source or drain region and the integrated circuit further comprises a second source or drain region at opposite ends of only the first subset of the semiconductor bodies such that the second subset of the semiconductor bodies does not contact the second source or drain region.

5. The integrated circuit of any one of claims 1 through 4, further comprising a dielectric layer over the ends of the second subset of the semiconductor bodies.

6. The integrated circuit of claim 5, wherein the dielectric layer comprises silicon and nitrogen.

7. The integrated circuit of any one of claims 1 through 6, wherein the semiconductor bodies are first semiconductor bodies, the integrated circuit further comprising a dielectric fill between the ends of the second subset of the first semiconductor bodies and laterally adjacent to ends of second semiconductor bodies, the second semiconductor bodies extending in the first direction.

8. The integrated circuit of claim 7, wherein the gate structure is a first gate structure, and the source or drain region is a first source or drain region, the integrated circuit further comprising:
a second gate structure extending in the second direction over the second semiconductor bodies; and
a second source or drain region at ends of only a first subset of the second semiconductor bodies such that a second subset of the semiconductor bodies does not contact the second source or drain region.

9. The integrated circuit of any one of claims 1 through 8, further comprising a conductive contact on a top surface of the source or drain region.

10. The integrated circuit of any one of claims 1 through 9, further comprising a subfin below the semiconductor bodies.

11. The integrated circuit of any one of claims 1 through 10, wherein the first subset includes two or three semiconductor bodies, and the second subset includes one or two semiconductor bodies.

12. The integrated circuit of any one of claims 1 through 11, wherein the semiconductor bodies are semiconductor nanoribbons.

13. The integrated circuit of any one of claims 1 through 11, wherein the semiconductor bodies are semiconductor nanosheets.

14. The integrated circuit of any one of claims 1 through 13, wherein the semiconductor bodies, the gate structure, and the source or drain region are at least part of a gate-all-around transistor device or a forksheet transistor device.

15. A printed circuit board comprising the integrated circuit of any one of claims 1 through 14.
